Europäisches Patentamt

European Patent Office

Office européen des brevets

(11) Publication number: **0 201 270**
**A2**

# EUROPEAN PATENT APPLICATION

(21) Application number: **86303251.2**

(22) Date of filing: **29.04.86**

(51) Int. Cl.⁴: **H 01 L 27/14**

(30) Priority: **01.05.85 JP 92288/85**

(43) Date of publication of application: **12.11.86**
**Bulletin 86/46**

(84) Designated Contracting States: **DE FR GB NL**

(71) Applicant: **CANON KABUSHIKI KAISHA, 30-2, 3-chome, Shimomaruko, Ohta-ku Tokyo (JP)**

(72) Inventor: **Matsumoto, Shigeyuki, 33-9-501 Asahi-cho 1-chome, Atsugi-shi Kanagawa-ken (JP)**
Inventor: **Suzuki, Toshiji, 33-70 Higashi Tamagawagakuen 1-chome, machida-shi Tokyo (JP)**

(74) Representative: **Beresford, Keith Denis Lewis et al, BERESFORD & Co. 2-5 Warwick Court High Holborn, London WC1R 5DJ (GB)**

(54) Photoelectric converting device.

(57) A photoelectric converting device comprises a plurality of photoelectric converting cells. The cells have a semiconductor transistor consisting of two main electrode regions formed of a semiconductor of one conductivity type and a control electrode region formed of a semiconductor of the opposite conductivity type, and a capacitor for controlling a potential of the control electrode region in the floating state.

Each of the photoelectric converting cells performs at least the operations to accumulate carriers generated due to an incident light into the control electrode region and read out an accumulated voltage generated due to the accumulated carriers by controlling the potential of the control electrode region in the floating state through the capacitor.

An isolating region for electrically isolating the adjacent photoelectric converting cells is formed of a semiconductor of the same conductivity type as that of said main electrode regions of the photoelectric converting cell.

TITLE OF THE INVENTION

Photoelectric Converting Device

BACKGROUND OF THE INVENTION

Field of the Invention

The present invention relates to a photoelectric converting device having a photocharge accumulating region whose potential is controlled through a capacitor.

Related background art

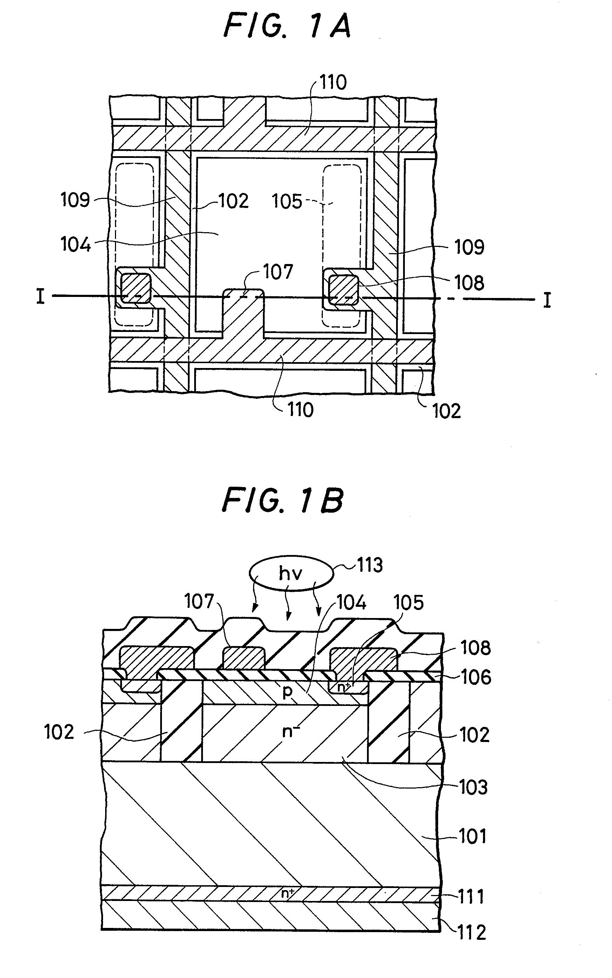

Fig. 1A is a plan view of a photoelectric converting device disclosed in the Official Gazette of EPC Application Laid-Open No.0132076 and Fig. 1B is a cross sectional view taken along the line I-I in Fig. 1A.

In these diagrams, photo sensor cells are formed and arranged on an $n^+$ silicon substrate 101. Each photosensor cell is electrically isolated from the adjacent photosensor cells by an element isolating region 102 consisting of $SiO_2$, $Si_3$, $N_4$, polysilicon, or the like.

Each photo sensor cell has the following constitution.

An $n^-$ region 103 having a low impurity concentration is first formed by an epitaxial technique or the like. A p region 104 is formed on the $n^-$ region 103 by doping p-type impurities. An

$n^+$ region 105 is formed in the p region 104 due to an impurity diffusion technique or ion implantation technique or the like. The p region 104 and $n^+$ region 105 serve as a base and an emitter of a bipolar transistor, respectively.

An oxide film 106 is formed over the $n^-$ region 103 on and over which the respective regions are formed in this manner. A capacitor electrode 107 having a predetermined area is formed on the oxide film 106. The capacitor electrode 107 faces the p region 104 through the oxide film 106. The potential of the P region 104 in the floating state is controlled by applying a pulse voltage to the capacitor electrode 107.

In addition, an emitter electrode 108 connected to the $n^+$ region 105, a wiring 109 to read out a signal from the emitter electrode 108 to the outside, and a wiring 110 connected to the capacitor electrode 107 are formed, respectively. Further, an $n^+$ region 111 having a high impurity concentration and an electrode 112 to apply a potential to a collector of the bipolar transistor are formed on the back side of the substrate 101, respectively.

The fundamental operation of the photoelectric converting device shown in Figs. 1A and 1B will then be described. A light 113 enters the p region 104 as the base of the bipolar transistor.

The charges corresponding to the incident light amount are accumulated in the p region 104 (accumulating operation). The base potential changes due to the charges accumulated. By reading out the potential change from the emitter electrode 108 in the floating state, an electrical signal corresponding to the incident light amount can be obtained (reading operation). To remove the charges accumulated in the p region 104, the emitter electrode 108 is grounded and a pulse of a positive voltage is applied to the capacitor electrode 107 (refreshing operation). By applying the positive voltage, the p region 104 is forwardly biased with respect to the $n^+$ region 105 and the charges accumulated are moved. Thereafter, the accumulating, reading, and refreshing operations are repeated, respectively.

In brief, according to the system proposed in the conventional example, the charges generated due to the light incidence are accumulated into the p region 104 as the base and the current flowing between the emitter electrode 108 and the collector electrode 112 is controlled on the basis of the amount of charges accumulated. Therefore, the accumulated charges are amplified due to the amplifying function of each cell and thereafter they are read out. Thus, the high power, high sensitivity, and further low noise can be accomplished.

On the other hand, a potential Vp generated in the base by the holes accumulated in the base due to the light excitation can be expressed by Q/C (Vp = Q/C), in which denotes a charge amount of holes accumulated in the base and C is a capacitance connected to the base. As will be apparent from this expression, in the case where the elements are highly integrated, the cell size is reduced and both values of Q and C also decrease, so that the potential Vp generated due to the light excitation is held almost constant. Therefore, the conventional system is also advantageous to realize the future high resolution.

However, according to the conventional photoelectric converting device, the element isolating region 102 to electrically isolate each cell is formed of a dielectric material (e.g., $SiO_2$ or the like). Therefore, although it is suitable to realize the high resolution, there is the problem such that the manufacturing process is complicated.

## SUMMARY OF THE INVENTION

It is an object of the present invention to provide a photoelectric converting device which can solve the foregoing conventional problem.

Another object of the invention is to provide a photoelectric converting device comprising a plurality of photoelectric converting cells each having: a semiconductor transistor consisting of two main electrode regions formed of one conductivity type semiconductor and a control electrode region formed of an opposite conductivity type semiconductor; and a capacitor to control a potential of the control electorde region in the floating state, wherein the photoelectric converting cell executes at least the operations to accumulate the carriers generated due to the incident light into the control electrode region and read out the accumulated voltage generated due to the accumulated carriers by controlling the potential of the control electrode region in the floating state through the capacitor, and the isolating region to electrically isolate the adjacent photoelectric converting cells consists of the semiconductor of the same conductivity type as the main electrode regions of the photoelectric converting cells.

BRIEF DESCRIPTION OF THE DRAWINGS

Fig. 1A is a schematic plan view of a conventional photoelectric converting device;

Fig. 1B is a cross sectional view taken along the line I-I in Fig. 1A ;

Fig. 2A is a schematic plan view of an embodiment of a photoelectric converting device according to the present invention;

Figs. 2B and 2C are cross sectional views of one cell taken along the line A-A' in Fig. 2A ; and

Figs. 3A to 3I are diagrams for explaining the manufacturing process of the embodiment.

## DETAILED DESCRIPTION OF PREFERRED EMBODIMENT

An embodiment of the present invention will be described in detail hereinbelow with reference to the drawings.

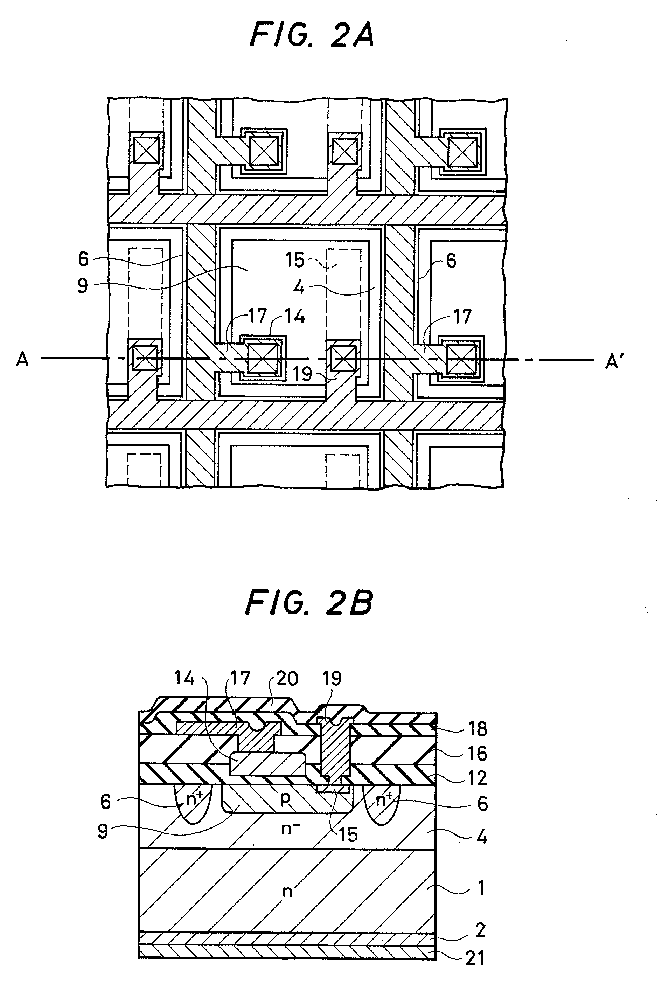

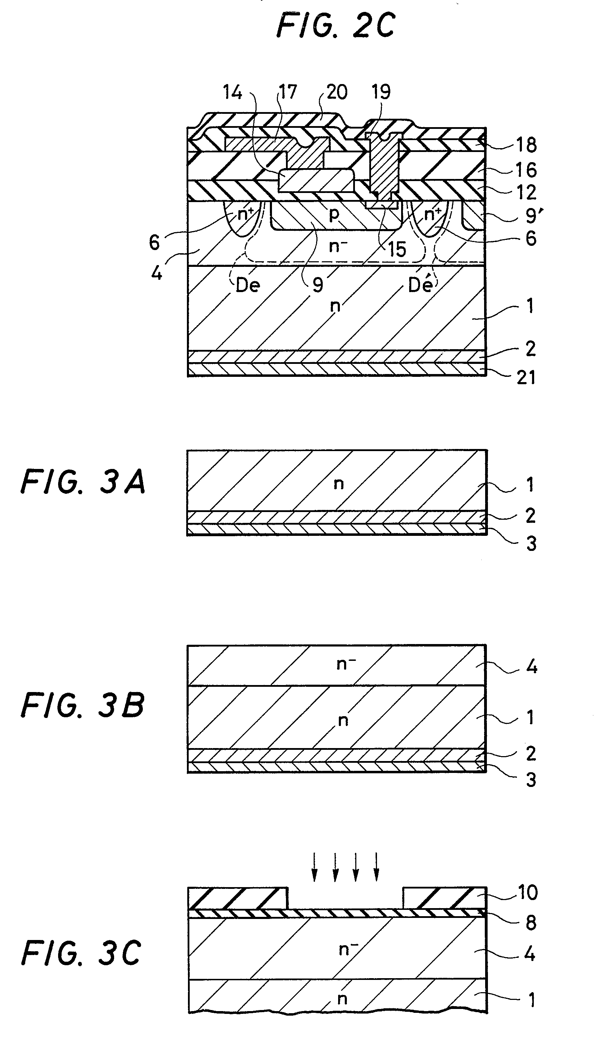

Fig. 2A is a schematic plan view of an embodiment of a photoelectric converting device according to the present invention. Figs. 2B and 2C are corss sectional views of one cell taken along the line A-A' in Fig. 2A

In Figs. 2A and 2B , an $n^-$ epitaxial layer 4 is formed on an n silicon substrate 1. Photo sensor cells electrically isolated from one another by an $n^+$ element isolating region 6 are arranged in the $n^-$ epitaxial layer 4.

Each photo sensor cell comprises:

a p base region 9 and an $n^+$ emitter region 15 of a bipolar transistor which are formed on and over the $n^-$ epitaxial layer 4;

a polysilicon layer 14 serving as an electrode to apply a pulse to the p base region 9 and also serving as an electrode of a capacitor and an electrode 19 connected to the $n^+$ emitter region 15, the polysilicon layer 14 and electrode 19 being arranged so as to sandwich the oxide film 12; and

an electrode 17 connected to the polysilicon layer 14, and an $n^+$ region 2 having a high impurity concentration and an electrode 21 to apply a potential to the collector of the bipolar transistor, the $n^+$ region 2 and electrode 21 being formed on the back side of the substrate 1.

The device of this embodiment fundamentally operates in the following manner. First, the p base region 9 biased to the negative potential is set to the floating state and the holes in the pairs of electrons and holes generated due to the light excitation are accumulated into the p base region 9 (accumulating operation). Subsequently, the region between the emitter and base of the bipolar transistor is forwardly biased and the accumulated voltage generated due to the accumulated holes is read out to the emitter side in the floating state (reading operation). By grounding the emitter side and applying a pulse of a positive voltage to the polysilicon layer 14 as the capacitor electrode, the holes accumulated in the p base region 9 are removed to the emitter side (refreshing operation). As the result of the removal of the accumulated holes, the p base region 9 becomes the initial state in which it is biased to the negative potential when the positive voltage pulse for refreshment trailed.

Fig. 2C shows the spreading state of a depletion layer De in this initial state. In this manner, it is prevented by the $n^+$ element isolating region 6 that the depletion layer De overlaps a depletion layer De' in the adjacent cell, so that the respective cells are certainly isolated.

Figs. 3A to 3I are diagrams for explaining the manufacturing process in this embodiment.

First, as shown in Fig. 3A, the $n^+$ layer 2 for ohmic contact having the impurity concentration of $1 \times 10^{17}$ to $1 \times 10^{20}$ cm$^{-3}$ is formed on the back side of the n-type silicon substrate 1 having the impurity concentration $1 \times 10^{15}$ to $5 \times 10^{18}$ cm$^{-3}$ due to the diffusion of P, As, or Sb. Subsequently, an oxide film 3 (e.g., $SiO_2$ film) having the thickness of 3000 to 7000 Å is formed under the $n^+$ layer 2 due to a CVD process.

The oxide film 3 is called the back coat and serves to prevent the generation of the impurity vapor when the substrate 1 is subjected to a heat treatment.

Next, the surface of the substrate 1 is etched for about one and half minutes at the temperature of 1000°C under the condition of HCℓ of 2ℓ/min and $H_2$ of 60ℓ/min. Thereafter, for example, a source gas of $SiH_2Cℓ_2$ (100%) of 1.2 ℓ/min and a doping gas ($PH_3$ diluted by $H_2$ to 20 PPM) of 100 mℓ are poured and the

$n^-$ epitaxial layer 4 (hereinafter, simply referred to as the $n^-$ layer 4) is formed at the growth temperature of 1000°C and at the reduced pressure of 120 to 180 Torr. In this case, the growth speed of the monocrystal is 0.5 μm/min and the thickness is 2 to 10 μm and the impurity concentration is $1 \times 10^{12}$ to $10^{16}$ cm$^{-3}$, preferably, $10^{12}$ to $10^{14}$ cm$^{-3}$ (refer to Fig. 3B ).

To improve the quality of the $n^-$ layer 4, it is fairly effective to form the substrate in the following manner. Namely, oxygen is first removed from the portion near the surface of the substrate due to the heat treatment at high temperatures of 1150 to 1250°C. Thereafter, the substrate is subjected to the heat treatment for a long time at temperatures of about 800°C to allow a number of microdefects to be generated in the substrate, thereby forming the substrate having the denuded zone which can perform the intrinsic gettering.

Then, an oxide film 8 for buffer having the thickness of 500 to 1500 Å is formed on the $n^-$ layer 4 by way of the pyrogeneic oxidation ($H_2 + O_2$), wet oxidation ($O_2 + H_2O$), steam oxidation ($N_2 + H_2O$), or dry oxidation. Further, the high pressure oxidation at the temperature of 800 to 1000°C is suitable to obtain the good oxide film having no stacking fault or the like.

The oxide film 8 serves to prevent the channeling and the surface fault when the base region is formed by way of the ion implantation. The oxide film 3 of the back coat is completely removed by this process.

Next, a resist 10 is coated and the portion which will become the base region is selectively removed (Fig. 3C ).

Subsequently, the $B^+$ ions or $BF_2^+$ ions produced using $BF_3$ as a material gas are implanted into the wafer. The surface concentration is $1 \times 10^{15}$ to $5 \times 10^{18}$ $cm^{-3}$, preferably, $1-20 \times 10^{16}$ $cm^{-3}$. The ion implantation amount is $7 \times 10^{11}$ to $1 \times 10^{15}$ $cm^{-2}$, preferably, $1 \times 10^{12}$ to $1 \times 10^{14}$ $cm^{-2}$.

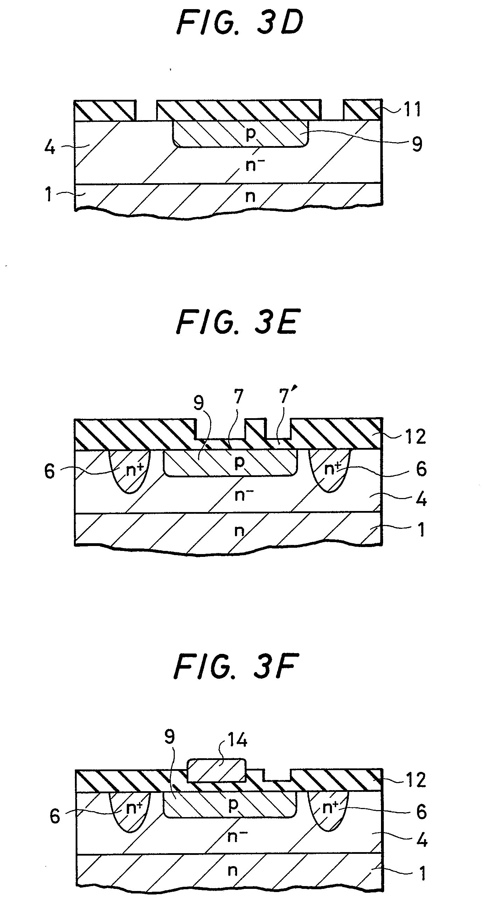

After the ions were implanted in this manner and the resist 10 was removed, the p base region 9 is formed until a predetermined depth due to the thermal diffusion at the temperature of 1000 to 1100°C in the $N_2$ gas. At the same time, an oxide film 11 is thickly formed on the surface of the substrate 1. Then, the oxide film 11 of the portion where the element isolating region 6 is formed is selectively removed (Fig. 3D ).

Although the depth of p base region 9 is, for example, about 0.6 to 1 μm, this depth and impurity concentration are determined by the following idea.

To improve the sensitivity, it is desirable to reduce the impurity concentration of the p base region 9 and decrease a capacitance Cbe between the base and emitter.  Cbe is nearly represented by the following expression.

$$Cbe = Ae\varepsilon \left( \frac{q \cdot N_A}{2\varepsilon \ Vbi} \right)^{1/2}$$

where, Vbi is a diffusion potential between the emitter and base and is given by the following expression.

$$Vbi = \frac{k \ T}{q} \ \ell n \ \frac{N_A \ N_D}{ni^2}$$

where, $\varepsilon$ is a dielectric constant of silicon crystal; $N_D$ is an impurity concentration of the emitter; $N_A$ an impurity concentration of the portion of the base adjacent to the emitter; ni an intrinsic carrier concentration; Ae an area of the base region; k a Boltzmann's constant; T an absolute temperature; and q a unit charge amount. As $N_A$ decreases, Cbe is reduced and the sensitivity increases.  However, when $N_A$ is too reduced, the base region is completely depleted in the operating state and becomes the punch through state.  Therefore, $N_A$ cannot be so reduced but may be set to a value such as to prevent that the base region is completely depleted and becomes the punch through state.

As a method of forming the base region, there is also the method whereby BSG is deposited on the wafer and impurities B are diffused until a predetermined depth due to the thermal diffusion at the temperature of 1100 to 1200°C thereby forming the base region 9.

Next, a diffusion which a causes quality is performed to form the element isolating region 6. It is desirable to set the concentration to $10^{17}$ to $10^{21}$ cm$^{-3}$. The diffusion method from POC$\ell_3$ and ion implantation method can be used as the method. The good result was obtained by the method using POC$\ell_3$ in this example. The conditions are such that the temperature of the furnace is 850 to 1000°C, an amount of carrier gas for the POC$\ell_3$ bubbles is 50 to 200 m$\ell$/min, and the treatment time is 10 to 40 min.

After the element isolating region 6 and base region 9 were formed as mentioned above, a thick oxide film 12 is further formed over the substrate 1 by way of the oxidation process. Then, the oxide film 12 of the portions where the capacitor electrode and emitter region are formed is selectively removed. A gate oxide film 7 and an oxide film 7' each having the thickness of 100 to 1000 Å are formed in the opening portions, respectively, (Fig. 3E ).

Thereafter, polysilicon doped with As is deposited by use of the ($N_2$ + $SiH_4$ + $AsH_3$) gas or ($H_2$ + $SiH_4$ + $AsH_3$) gas due to the CVD process. The deposition temperature is about 550 to 900°C and the thickness is 2000 to 7000 Å. It is also possible to preliminarily deposite non-doped polysilicon due to the CVD process and then diffuse As or P. The polysilicon film deposited in this way is partially etched and removed due to the photo lithography process, thereby forming the polysilicon layer 14 as the capacitor electrode (Fig. 3F ).

Next, the impurity ions of P, As, or the like are implanted into the portion where the emitter region is formed through the oxide film 7' due to the ion implantation method and subjected to the heat treatment, thereby forming the $n^+$ emitter region 15 (Fig. 3G ).

In this case, the emitter region 15 was formed by the ion implantation method. However, the following method may be also used to form the $n^+$ emitter region 15. Namely, the oxide film 7' is removed and polysilicon is deposited onto the opening portion simultaneously with the polysilicon layer 14. The impurities of P or As or the like in the polysilicon layer are diffused into the p base region 9 due to the heat treatment, thereby forming the $n^+$ emitter region 15.

Next, a PSG film or $SIO_2$ film 16 having the thickness of 3000 to 7000 $\overset{\circ}{A}$ is deposited by use of the foregoing gas system due to the CVD process. Subsequently, a contact hole is formed on the polysilicon layer 14 due to the mask matching process and etching process. The electrode 17 (metal of

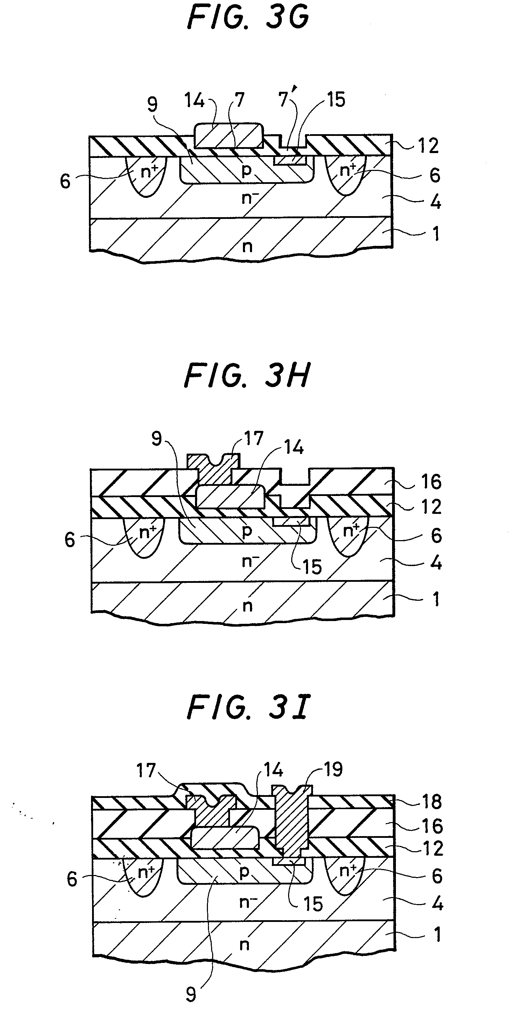

Al, Al-Si, Al-Cu-Si, or the like) is deposited on the contact hole due to the vacuum evaporation or sputtering (Fig. 3H ).

Then, an insulating film 18 between layers such as PSG film, $SiO_2$ film, or the like is deposited so as to have the thickness of 3000 to 9000 Å due to the CVD process. A contact hole is formed in the emitter region 15 due to the mask matching process and etching process and the electrode 19 (metal of Al, Al-Si, Al-Cu-Si, or the like) is formed (Fig. 3I ).

Finally, a passivation film 20 (PSG film, $Si_3N_4$ film, or the like) is formed due to the CVD process. The electrode 21 (metal of Al, Al-Si, Au, or the like) is formed on the back surface of the wafer. In this manner, the photoelectric converting device shown in Figs. 2A and 2B is formed.

Although the $n^+$ semiconductor was used as the element isolating region 6 is this embodiment, the invention is not limited to this material. A $p^+$ semiconductor may be used in the case of a PNP bipolar transistor.

As described in detail above, according to the photoelectric converting device in the embodiment, the isolating region to electrically isolate the respective cells is formed of the semiconductor of the same conductivity type as that of the main electrode region of the semiconductor transistor of each cell.  Therefore, there is no need to form the isolating region of the insulating material by the complicated process as in the conventional device. The isolating region can be easily formed by the ordinary diffusion method, ion implantation method, or the like.  In addition, since no parasitic transistor is formed between the cell and the isolating region, the respective cells are certainly isolated and each cell can stably operate.

CLAIMS:

1. A photoelectric converting device comprising a plurality of photoelectric converting cells which are arranged and each of which has:

a semiconductor transistor consisting of two main electrode regions formed of a semiconductor of one conductivity type and a control electrode region formed of a semiconductor of the opposite conductivity type; and

a capacitor for controlling a potential of said control electrode region in the floating state,

wherein each of said photoelectric converting cells performs at least the operations to accumulate carriers generated due to a incident light into said control electrode region and read out an accumulated voltage generated due to said accumulated carriers by controlling the potential of said control electrode region in the floating state through said capacitor,

and an isolating region for electrically isolating the adjacent photoelectric converting cells is formed of a semiconductor of the same conductivity type as that of said main electrode regions of said photoelectric converting cell.

## FIG. 1A

## FIG. 1B

## FIG. 2A

## FIG. 2B

*FIG. 2C*

*FIG. 3A*

*FIG. 3B*

*FIG. 3C*

## FIG. 3D

## FIG. 3E

## FIG. 3F

## FIG. 3G

9  14  7  7'  15
12
6  n+  p  n+  6
4
n−
1
n

## FIG. 3H

9  17  14
16
12
6  n+  p  n+  6
15
4
n−
1
n

## FIG. 3I

17  14  19
18
16
12
6  n+  p  n+  6
15
4
n−
1
n
9